# EUROPÄISCHE PATENTSCHRIFT

(11) **EP 1 275 462 B1**
(45) Veröffentlichungstag und Bekanntmachung des Hinweises auf die Patenterteilung: **30.08.2006**
(21) Anmeldenummer: 02014075.2
(22) Anmeldetag: 01.07.2002
(51) Int. Cl.: B23K 1/012

(54) **Verfahren und Vorrichtung zum Verlöten von elektrischen Bauteilen auf einer Kunststofffolie**
Method and apparatus for soldering electronic devices to a polymer film
Procédé et dispositif pour souder des éléments électriques sur une feuille plastique

(30) Priorität: 09.07.2001 DE 10133217
(43) Veröffentlichungstag der Anmeldung: 15.01.2003
(73) Patentinhaber: Seho Systemtechnik GmbH, 97892 Kreuzwertheim (DE)
(72) Erfinder: Diehm, Rolf Ludwig, 97877 Wertheim (DE); Liedtke, Volker, 76774 Leimersheim (DE)
(74) Vertreter: Bardehle, Heinz

(56) Entgegenhaltungen:
- WO-A-94/21415
- US-A- 4 610 388
- US-A- 4 927 068
- US-A- 5 433 368

## Beschreibung

Die Erfindung bezieht sich auf ein Verfahren und eine Vorrichtung zum Verlöten von elektrischen Bauteilen an mit Lötwerkstoff versehenen Lötstellen auf einer mit aufgebrachten Leiterbahnen versehenen Kunststofffolie.

Kunststofffolien mit aufgebrachten Leiterbahnen und damit verlötete elektrischen Bauteilen sind vorteilhaft dann anwendbar, wenn eine Verlegung von elektrischen Leitungen in einer Weise erfolgt, bei der der betreffende Träger eine gewisse Flexibilität aufweisen muss.

Aus diesen Gründen hat man bereits Kunststofffolien als Träger für Leiterbahnen und elektrische Bauteile verwendet, die wegen der beim Verlöten der elektrischen Bauteilen erforderlichen Temperaturen, die etwa bei 210°C liegen, eine entsprechende Wärmebeständigkeit aufweisen müssen. Derartige Kunststoffe sind teuer. Bisher hat man in diesem Zusammenhang als zugrunde liegenden Kunststoff Polyamid (PI) verwendet. Wegen der mit diesem Kunststoff verbundenen Kosten kommt eine daraus gefertigte Kunststofffolie als Träger für Leiterbahnen in vielen Techniken nicht in Frage. Dies gilt vor allem für den Automobilbau, in dem Leiterbündel innerhalb eines Kraftfahrzeuges an vielen Stellen zu verlegen sind, wobei die betreffenden Träger beim Einsetzen der Leiterbahnen in ein in Fertigung befindliches Kraftfahrzeug erheblichen Beanspruchungen ausgesetzt werden.

Der Versuch, billigere Kunststoffe als Träger für Leiterbahnen zu verwenden, ist bisher daran gescheitert, dass technisch geeignete und ausreichend billige Kunststoffe die beim Verlöten auftretenden Temperaturen nicht vertragen. Entweder liegt der Aufgabe zugrunde, das eingangs geschilderte Verfahren so zu gestalten, dass es für bekannte, relativ billige Kunststoffe geeignet ist, wie Polyester-Derivate (PEN, PEPT), ohne dass bei der Verwendung dieser Kunststoffe diese beim Verlöten irgendwie beeinträchtigt werden.

Erfindungsgemäß geschieht dies dadurch, dass die Kunststofffolie auf einer unterhalb ihrer Schädigungstemperatur von der den Bauteilen abgewandten Seite her aufgeheizt und nach dem Aufheizen ihre den Bauteilen abgewandte Seite wärmeisoliert wird und danach die den Bauteilen zugewandte Seite mit einem Heizgasstrom beaufschlagt wird, der durch eine Fenster aufweisende Schablone auf die zu verlötenden Stellen konzentriert wird.

Bei diesem Verfahren wird erreicht, dass die Wärmezufuhr zu der Kunststofffolie auf ein Minimum begrenzt wird und nur dort einen höheren das Aufschmelzen des Lots ermöglichenden Wert erreicht, wo bereits Lötwerkstoff vorgesehen ist. Dies geschieht dadurch, dass zunächst aufgrund der Aufheizung der Kunststofffolie auf den dicht unterhalb ihrer Schädigungstemperatur liegenden Betrag die insgesamt der Kunststofffolie zuzuführende Energie stark begrenzt ist. Es wird auch durch die Aufheizung der Kunststofffolie von dieser wegen ihrer geringen Wärmeleitfähigkeit verbleiben und bestimmt durch den Temperaturunterschied zwischen Kunststofffolie und Schmelztemperatur des Lots nur relativ wenig Wärme mit einer minimalen Energie auskommt. Die dann an den Lötstellen aufzubringende durch den Heizgasstrom erzeugte höhere Wärme, lässt sich durch die Fenster aufweisende Schablone so stark konzentrieren, dass nur die zu verlötenden Stellen einem erhöhten Wärmezustrom ausgesetzt sind, womit die umgebenen Bereiche der Kunststofffolie praktisch keiner zusätzlichen Erwärmung ausgesetzt werden und daher eine Schädigung der Kunststofffolie durch erhöhte Erwärmung nicht auftreten kann. Um dabei ein Abfließen von Wärme von der aufgeheizten Kunststofffolie zu vermeiden, was einen zusätzlichen unerwünschten Wärmebedarf auf Seiten der Kunststofffolie zur Folge hätte, wird nach dem Aufheizen der Kunststofffolie deren den Bauteilen abgewandte Seite wärmeisoliert. Solange diese Wärmeisolation besteht, behält daher die Kunststofffolie ihre durch Aufheizen gegebene Temperatur bei.
Es wird noch darauf hingewiesen, dass in der internationalen Patentanmeldung WO 94/21415 in Zusammenhang mit Reflow-Löten von Flachbaugruppen, bei dem das Aufheizen der Lötstellen durch Strahlung in einem Heizraum erfolgt. Um dabei in dem Heizraum ausgewählte Bereiche von der Strahlung auszunehmen, wird in der Druckschrift ein Maskenträger vorgeschlagen, der aus einer Position außerhalb des Heizraumes in den Heizraum hinein verlagerbar und auf der Flachbaugruppe (Platine) absenkbar ist, wodurch für eine vorgegebene Zeit der ausgewählte Bereich gegen die Strahlung abgeschattet ist. Diese Lötmethode kommt für Kunststofffolien wegen der dabei entstehenden hohen Wärmeeinbringung nicht in Frage, da die durch die Erfindung verwendbaren Polyester-Derivate in dem durch die Strahlung aufgeheizten Heizraum sofort zusammenschmelzen würden.

Um den Vorgang der Wärmezufuhr möglichst zu konzentrieren und damit so kurzzeitig wie möglich zu gestalten, gestaltet man das Aufheizen der Kunststofffolie und der Wärmebeaufschlagung der den Bauteilen zugewandten Seite der Kunststofffolie zweckmäßig so, dass dies im Wesentlichen gleichzeitig erfolgt.

Für die Durchführung des Lötvorganges regelt man die Temperatur des Heizgasstroms bei festgehaltener Kunststofffolie praktisch in der Weise, dass zunächst eine Vorheizung der Lötstellen für eine den Lötwerkstoff aktivierende Zeit erfolgt, woraufhin die Temperatur des Heizgasstrom bis zum Schmelzen des im Lötwerkstoff enthaltenen Lots kurzzeitig erhöht und danach schnell abgesenkt wird. Aufgrund dieser Verfahrensweise wird dafür gesorgt, dass für das eigentliche Löten, das beim Schmelzen des im Lötwerkstoff enthaltenen Lots erfolgt, nur eine minimale Zeit erforderlich ist, da vor dem Schmelzen des Lötwerkstoffs die Vorheizung der Lötstellen für eine den Lötwerkstoff aktivierenden Zeit erfolgt, so dass also nur ein ganz kurzzeitiger Temperaturstoß erforderlich ist, um das Lot zum Schmelzen zu bringen, wodurch die Kunststofffolie sicher vor einer zu hohen Erwärmung geschützt wird.

Das Absenken der Temperatur des Heizgasstrom nach dem Löten geschieht zweckmäßig dadurch, dass der Heizgasstrom nach dem Schmelzen abgeschaltet wird. Darüber hinaus ist es auch möglich den Heizgasstrom in einen Kühlstrom umzuwandeln, um besonders schnell dafür zu sorgen, dass keinerlei schädigende Wärme im Bereich der Kunststofffolie verbleiben kann.

In der US-PS 5,433,368 ist eine Vorrichtung mit Heizelementen beschrieben, die beiderseits eines Transporteurs vorgesehen sind, auf dem zu verlötende Bauteile transportiert werden. Diese Vorrichtung ist derart gestaltet, dass auf der die Bauelemente tragenden Seite des Transporteurs stationäre Wärmestrahler angeordnet sind, deren Strahlung durch Schablonen kanalisiert wird. Auf der anderen Seite des Transporteurs sind Heizgasgebläse vorgesehen, die einen heißen Gasstrom auf die Rückseite des Transporteurs richten.

Die Erfindung bezieht sich weiterhin auf eine Vorrichtung zur Durchführung des vorstehend beschriebenen Verfahrens. Es handelt sich dabei um eine Vorrichtung zum Verlöten von elektrischen Bauteilen an mit Lötwerkstoff versehenen Lötstellen auf einer mit aufgebrachten Leiterbahnen versehenen Kunststofffolie, die auf einer unterhalb ihrer Schädigungstemperatur von der den Bauteilen abgewandten Seite her aufgeheizt und nach dem Aufheizen diese den Bauteilen abgewandte Seite wärmeisoliert und danach die den Bauteilen zugewandte Seite mit einem Heizgasstrom beaufschlagt wird, der durch eine Fenster aufweisende Schablone auf die zu verlötenden Stellen konzentriert wird, mit einem auf derjenigen Seite der Kunststofffolie, an der die Bauteile gehalten sind, ein Heizgasgebläse aufweist, vor dem die Kunststofffolie positionierbar ist, wobei zwischen Heizgasgebläse und Kunststofffolie die Schablone einschiebbar angeordnet ist. Diese Vorrichtung ist dadurch gekennzeichnet, dass auf der dem Heizgasgebläse abgewandten Seite der Kunststofffolie eine Heizplatte zum Vorheizen der Kunststofffolie vorgesehen ist, die hinsichtlich ihres Abstandes von der Kunststofffolie derart einstellbar angeordnet ist, dass sie zur Aufheizung der Kunststofffolie zumindest in einem geringen Abstand und zur Isolierung der Kunststofffolie in vergrößertem Abstand zu dieser gehalten wird.

Die Aufheizung der Kunststofffoliemittels der Heizplatte verringert den Wärmebedarf für das Verlöten der elektrischen Bauteile. Um dann während des Verfahrensschritts des Lötens eine übermäßige Wärmezufuhr von der Heizplatte zu verhindern, wird diese abgesenkt und bildet damit durch Vergrößern des Abstandes der Heizplatte von der Kunststofffolie einen mit Gas gefüllten größeren Zwischenraum, der wie eine Isolation wirkt.

Um auch auf Seiten des Heizgebläses die Energie hinsichtlich der zu beaufschlagenden Stellen zu konzentrieren, versieht man das Heizgasgebläse zweckmäßig mit positionierbaren Auslässen, wodurch sich jede beliebige Strömungskonzentration auf ausgewählte Stellen ermöglichen lässt insbesondere natürlich auf die zu verlötenden Stellen. Für die Schablone kann man vorteilhaft einen flächigen Werkstoff verwenden, der eine geringe Wärmeleitfähigkeit besitzt. In diesem Fall kann man die Schablone leicht gegen die Kunststofffolie drücken und diese damit während des Lötprozesses festhalten. Es ist aber auch möglich, die Schablone aus einem Metallblech zu gestalten, das in diesem Falle wegen der hohen Wärmeleitfähigkeit von Metall in einem Abstand zu dieser Kunststofffolie zu halten ist. Darüber hinaus ist es möglich, die Schablone mit einem Innenraum für die Aufnahme eines Kühlmediums zu versehen. Auf diese Weise lässt sich mittels der gekühlten Schablone dafür sorgen, dass die von der Schablone abgedeckten Bereiche der Kunststofffolie durch deren niedrige Temperatur zusätzlich besonders geschützt werden.

In den Figuren sind Ausführungsbeispiele der Erfindung dargestellt. Es zeigen:
- Fig.1:: die Positionierung des Lötguts (Kunststofffolie mit aufgebrachten Leiterbahnen und elektrischen Bauteilen) positioniert in der Vorrichtung;
- Fig. 2:: das Vorheizen des Lötguts;
- Fig. 3:: das Löten mit Heizgas;
- Fig. 4:: der Auslauf des gelöteten Lötguts aus der Vorrichtung;
- Fig. 5:: die Anordnung einer Metallschablone in Bezug auf das Lötgut;
- Fig. 6:: die Anordnung einer Schablone aus Material mit geringer Wärmeleitfähigkeit;
- Fig. 7:: die Anordnung einer Schablone mit Innenkühlung in Bezug auf das Lötgut;
- Fig. 8:: eine Heizgaszuführung mit umfassender Erstreckung;
- Fig. 9:: eine Heizgaszuführung konzentriert durch Düsen;
- Fig. 10:: ein Ausführungsbeispiel für ein als Flexleiter ausgebildetes Lötgut;
- Fig. 11a, b, c :: verschieden aufgebrachter Lotwerkstoff;
- Fig. 12:: ein Zeitprofil zum Verlöten mittels Lotpaste.

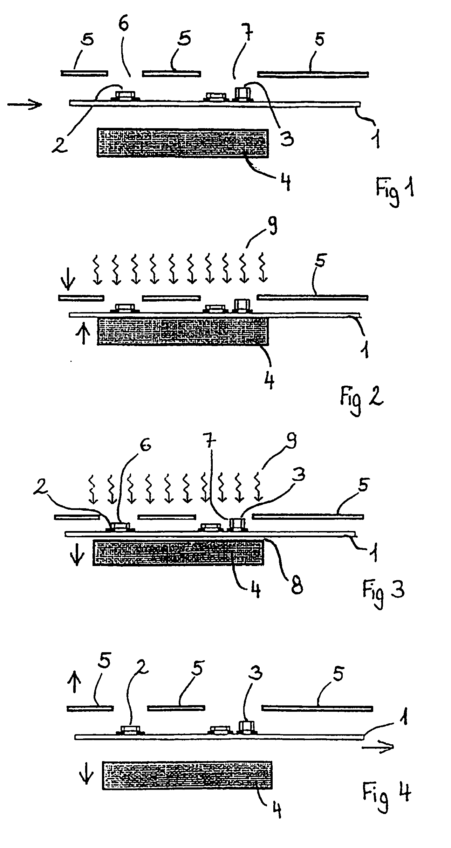

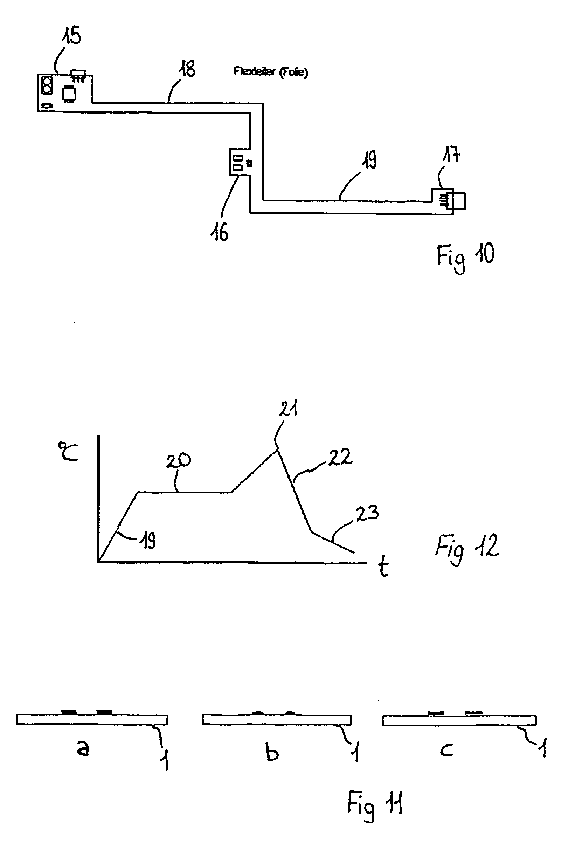

In Fig. 1 sind die für die Durchführung des Verfahrens erforderlichen Bauteile in prinzipieller Darstellung gezeigt, und zwar die Kunststofffolie 1 mit aufgebrachten elektrischen Bauteilen 2, 3 (Einzelbauteile und integrierte Schaltkreise), die auf der betreffenden Oberfläche der Kunststofffolie 1 durch in Fig. 1 nicht sichtbare Leiterbahnen (siehe Fig. 10) verbunden sind. Unterhalb der Kunststofffolie ist die für die Aufheizung der Kunststofffolie 1 dienende Heizplatte 4 angeordnet, oberhalb der Kunststofffolie 1 die ein- und ausschiebbare Schablone 5, in die Fenster 6 und 7 eingeschnitten sind, wodurch eine weiter unten erläuterte Wärmezufuhr auf den Bereich dieser Fenster begrenzt wird. Die Fig. 1 zeigt die Vorrichtung im Zustand der Positionierung des Lötguts, wobei zunächst aus räumlichen Gründen die Heizplatte 4 und die Schablone 5 einen gewissen Abstand von dem Lötgut einhalten.

In Fig. 2 ist der Verfahrensschritt der Aufheizung der Kunststofffolie 1 mittels der Heizplatte 4 dargestellt, die gemäß dem neben der Heizplatte 4 dargestellten Pfeil an die Kunststofffolie 1 herangeführt ist, und zwar an die den elektrischen Bauteilen abgewandte Seite. Mittels der an der Kunststofffolie 1 anliegenden Heizplatte 4, die gegebenenfalls auch mit einem geringen Abstand von der Kunststofffolie gehalten werden kann, wird nun die Kunststofffolie 1 aufgeheizt, wodurch, wie oben erwähnt, der weitere Wärmebedarf für das Verlöten der elektrischen Bauteile entsprechend vermindert wird. Während dieses Aufheizvorganges erfolgt bereits die Zuführung von Wärme zu der die elektrischen Bauteile tragenden Seite der Kunststofffolie 1 durch den Heizgasstrom 6. Es sei jedoch darauf hingewiesen, dass die Zuführung des Heizgasstromes nicht nur während der Aufheizung der Kunststofffolie erfolgen kann, sondern auch nachdem die Heizung der Kunststofffolie begonnen hat.

Fig. 3 zeigt die Vorrichtung im Zustand des Verfahrensschritts des Lötens durch den Heizgasstrom 6, wobei zwecks Vermeidung übermäßiger Wärmezufuhr zu der Kunststofffolie 1 die Heizplatte 4 gegenüber der Position gemäß Fig. 2 geringfügig abgesenkt ist und damit einen kleinen Zwischenraum 8 zwischen Kunststofffolie 1 und Heizplatte 4 herbeiführt, der den Effekt einer Wärmeisolierung hat, so dass einerseits von der Heizplatte 4 keine Wärme mehr an die Kunststofffolie 1 abgegeben werden kann, andererseits diese aber auch ihre Temperatur nicht verliert. Der durch die Fenster 6 und 7 in der Schablone 5 auf die elektrischen Bauteile 2 und 3 einwirkende Heizgasstrom 9 wird durch die Fenster 2 und 3 kanalisiert und auf die elektrischen Bauteile 2 und 3 konzentriert, so dass eine übermäßige Erwärmung der Kunststofffolie 1 vermieden wird.

In der Fig. 4 ist die Vorrichtung in der Position dargestellt, in der die Kunststofffolie 1 mit den auf ihr verlöteten elektrischen Bauteilen 2 und 3 sowie den diese verbindenden Leiterbahnen verlötet aus der Vorrichtung ausgeführt wird (siehe Pfeil bei der Kunststofffolie 1), wobei vorher die Schablone 5 und die Heizplatte 4 von der Kunststofffolie 1 wegbewegt worden sind.

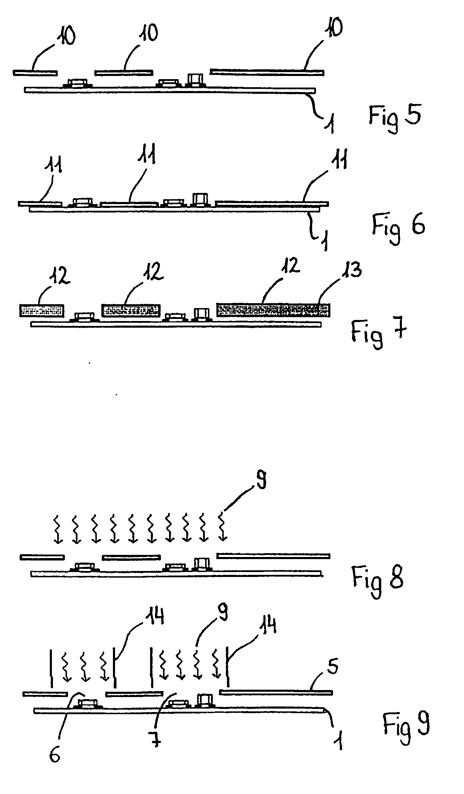

Wie bereits oben erwähnt, können für die Schablonen verschiedene Materialien verwendet werden. In Fig. 5 ist die Verwendung einer Metallschablone 10 schematisch angedeutet, die beim Löten in einem Abstand von der Kunststofffolie 1 gehalten wird. Bei der Darstellung gemäß Fig. 6 handelt es sich um eine Schablone mit geringer Wärmeleitfähigkeit, also gegebenenfalls um einen wärmebeständigen Kunststoff, der beim Löten auf die Kunststofffolie 1 aufgelegt wird.

Fig. 7 zeigt die Verwendung einer Schablone 12 mit Innenkühlung. Es handelt sich dabei um eine Schablone mit einem Hohlraum 13, der von einem Kühlmedium durchströmt wird. Mit dieser Schablone lässt sich eine gegebenenfalls wünschenswerte schnelle Abkühlung der Kunststofffolie mit den verlöteten elektrischen Bauteilen herbeiführen, was darum von Vorteil ist, weil bei schneller Abkühlung der Kunststofffolie nach dem Löten diese besonders gut vor einer Schädigung bewahrt wird.

In den Fig. 8 und 9 ist in Gegenüberstellung die Beaufschlagung der Kunststofffolie mit dem Heizgasstrom 9 dargestellt, und zwar gemäß Fig. 8, mit umfassender Zuführung (siehe Fig. 2 und 3) und in Fig. 9 mit der Zuführung des Heizgasstroms über schematisch dargestellte Düsen 14, die zusätzlich zu den Fenstern 6 und 7 in der Schablone 5 eine besondere Konzentrierung des Heizgasstroms 9 bewirken und damit eine Erwärmung der Kunststofffolie 1 im Bereich außerhalb der elektrischen Bauteile unterdrücken.

In der Fig. 10 ist ein Ausführungsbeispiel eines Lötguts in Form eines sog. Flexleiters dargestellt, der aus den größeren Folienbereichen 15, 16 und 17 und den diese verbindenden Leitungsstrecken 18 und 19 besteht, wobei die letzteren schmale Streifen der Kunststofffolie bilden, auf die elektrische Leiterbahnen aufgebracht sind. Derartige Flexleiter erlauben die Verlegung innerhalb enger Räume, z.B. in der Karosserie eines Automobils, in dem die Verbindungen vielfach an mehreren Stellen eng gekrümmt verlaufen müssen und in die Karosserieform entsprechend einzupassen sind. Dies ist bei der Verwendung von Flexleitern besonders einfach und gegenüber normalen Verdrahtungen darum vorteilhaft, weil Verdrahtungen bei derartiger Verlegung immer erheblichen Biegebeanspruchungen ausgesetzt sind und dabei brechen können.

In der Fig. 11 a, b, c sind verschiedene Lötwerkstoffe dargestellt, die auf die Kunststofffolie 1 aufgebracht sind und mittels des vorstehend beschriebenen Verfahrens gelötet werden können. Bei der Fig. 11 a handelt es sich um aufgedruckte Lötpaste, bei Fig. 11b um eine Reflow-Vorbelotung und bei Fig. 11c um aufgeklebtes Lot-Preform.

In Fig. 12 ist das Temperaturprofil bei Anwendung des vorstehend beschriebenen Verfahrens über der Zeitachse t dargestellt. Danach erfolgt zunächst das Vorheizen des Lötguts im Bereich 19, woraufhin bei erreichter Vorheiztemperatur diese über den Bereich 20 festgehalten wird, in dem der Lötwerkstoff aktiviert wird, woraufhin durch den Heizgasstrom eine kurzzeitige Erhöhung der Temperatur der Lötstellen bis zur Temperaturspitze 21 das Löten erfolgt. Danach erfolgt über den Bereich 22 die schnelle Absenkung der zugeführten Wärme, wobei es sich auch um einen gekühlten Gasstrom handeln kann, der, wie ersichtlich, schnell die Temperatur des Lötguts absenkt, die dann endgültig über den Bereich 23 zur Zimmertemperatur abklingt. Aus dem Diagramm gemäß Fig. 12 ist ersichtlich, dass die zum Verlöten erforderliche Temperatur über einen kurzen Temperaturstoß bis zur Temperaturspitze 21 erfolgt, so dass also die Temperaturbelastung des Lötguts und damit insbesondere der Kunststofffolie auf ein Minimum begrenzt wird.

## Patentansprüche

1. Verfahren zum Verlöten von elektrischen Bauteilen (2, 3) an mit Lötwerkstoff versehenen Lötstellen auf einer mit aufgebrachten Leiterbahnen versehenen Kunststofffolie (1), **dadurch gekennzeichnet, dass** die Kunststofffolie (1) auf einer unterhalb ihrer Schädigungstemperatur von der den Bauteilen (2, 3) abgewandten Seite her aufgeheizt und nach dem Aufheizen ihre den Bauteilen (2, 3) abgewandte Seite wärmeisoliert wird und danach die den Bauteilen zugewandte Seite mit einem Heizgasstrom (9) beaufschlagt wird, der durch eine Fenster (6, 7) aufweisende Schablone (5) auf die zu verlötenden Stellen konzentriert wird.

2. Verfahren nach Anspruch 1, **dadurch gekennzeichnet, dass** das Aufheizen der Kunststofffolie (1) und die Wärmebeaufschlagung der den Bauteilen (2, 3) zugewandten Seite der Kunststofffolie (1) im Wesentlichen gleichzeitig erfolgt.

3. Verfahren nach Anspruch 1 oder 2, **dadurch gekennzeichnet, dass** bei festgehaltener Kunststofffolie (1) die Temperatur des Heizgasstroms (9) derart geregelt wird, dass zunächst eine Vorheizung der Lötstellen für eine den Lötwerkstoff aktivierende Zeit erfolgt, woraufhin die Temperatur des Heizgasstroms (9) bis zum Schmelzen des im Lötwerkstoff enthaltenen Lots kurzzeitig erhöht und danach schnell abgesenkt wird.

4. Verfahren nach Anspruch 3, **dadurch gekennzeichnet, dass** der Heizgasstrom (9) nach dem Schmelzen abgeschaltet wird.

5. Verfahren nach Anspruch 3, **dadurch gekennzeichnet, dass** der Heizgasstrom (9) in einen Kühlstrom umgewandelt wird.

6. Vorrichtung zum Verlöten von elektrischen Bauteilen (2, 3) an mit Lötwerkstoff versehenen Lötstellen auf einer mit aufgebrachten Leiterbahnen versehenen Kunststofffolie (1), die auf einer unterhalb ihrer Schädigungstemperatur von der den Bauteilen (2, 3) abgewandten Seite her aufgeheizt und nach dem Aufheizen diese den Bauteilen (2, 3) abgewandte Seite wärmeisoliert und danach die den Bauteilen (2, 3) zugewandte Seite mit einem Heizgasstrom (9) beaufschlagt wird, der durch eine Fenster (6, 7) aufweisende Schablone (5) auf die zu verlötenden Stellen konzentriert wird, mit einem auf derjenigen Seite der Kunststofffolie (1), an der die Bauteile (2, 3) gehalten sind, ein Heizgasgebläse (9) aufweist, vor dem die Kunststofffolie (1) positionierbar ist, wobei zwischen Heizgasgebläse (9) und Kunststofffolie (1) die Schablone (5) einschiebbar angeordnet ist, **dadurch gekennzeichnet, dass** auf der dem Heizgasgebläse (9) abgewandten Seite der Kunststofffolie (1) eine Heizplatte (4) zum Vorheizen der Kunststofffolie (1) vorgesehen ist, die hinsichtlich ihres Abstandes von der Kunststofffolie (1) derart einstellbar angeordnet ist, dass sie zur Aufheizung der Kunststofffolie (1) zumindest in einem geringen Abstand und zur Isolierung der Kunststofffolie (1) in vergrößertem Abstand zu dieser gehalten wird.

7. Vorrichtung nach Anspruch 6, **dadurch gekennzeichnet, dass** das Heizgasgebläse mit positionierbaren Auslässen (14) zur Strömungskonzentration auf ausgewählte Stellen versehen ist.

8. Vorrichtung nach Anspruch 6 oder 7, **dadurch gekennzeichnet, dass** die Schablone (10) aus einem in Abstand zu der Kunststofffolie (1) gehaltenen Metallblech besteht.

9. Vorrichtung nach Anspruch 6 oder 7, **dadurch gekennzeichnet, dass** die Schablone (11) aus einem flächigen Werkstoff mit geringe Wärmeleitfähigkeit besteht.

10. Vorrichtung nach Anspruch 8 oder 9, **dadurch gekennzeichnet, dass** die Schablone (12) einen Innenraum (13) für die Aufnahme eines Kühlmediums aufweist.

## Claims

1. Process for soldering electrical components (2, 3) to soldering positions, which are provided with soldering material, on a plastic sheet (1) provided with applied conductor tracks, **characterized in that** the plastic sheet (1) is heated, from the side which is remote from the components (2, 3), to a below its damage temperature and after heating its side which is remote from the components (2, 3) is thermally insulated, and then the side which faces the components is acted on by a heating-gas stream (9) which is concentrated onto the locations which are to be soldered by a template (5) which has windows (6, 7).

2. Process according to Claim 1, **characterized in that** the heating of the plastic sheet (1) and the application of heat to that side of the plastic sheet (1) which faces the components (2, 3) takes place substantially simultaneously.

3. Process according to Claim 1 or 2, **characterized in that**, with the plastic sheet (1) held securely, the temperature of the heating-gas stream (9) is regulated in such a manner that initially the soldering locations are preheated for a time which activates the soldering material, whereupon the temperature of the heating-gas stream (9) is briefly increased, until the solder contained in the soldering material melts, and is then rapidly reduced.

4. Process according to Claim 3, **characterized in that** the heating-gas stream (9) is switched off after the melting.

5. Process according to Claim 3, **characterized in that** the heating-gas stream (9) is converted into a cooling stream.

6. Device for soldering electrical components (2, 3) to soldering positions, which are provided with soldering material, on a plastic sheet (1) provided with applied conductor tracks, being heated from the side which is remote from the components (2, 3) to a below its damage temperature and after heating its side which is remote from the components (2, 3) being thermally insulated, and then the side which faces the components is acted on by a heating-gas stream (9) which is concentrated onto the locations which are to be soldered by a template (5) which has windows (6, 7), having a heating-gas blower (9) at the side of the plastic sheet (1) on which the components (2, 3) are held, in front of which the plastic sheet (1) can be positioned, the template (5) being arranged in such a manner that it can be pushed in between the heating-gas blower (9) and the plastic sheet (1), **characterized in that** a heating plate (4) for preheating the plastic sheet (1) is provided at the side of the plastic sheet (1) remote of the heating-gas blower (9), being arranged to be adjustable with regard to the distance to the plastic sheet (1), so that it is held at least at a smaller distance for heating the plastic sheet (1) and at a longer distance for isolating the plastic sheet (1).

7. Device according to Claim 6, **characterized in that** the heating-gas blower is provided with positionable outlets (14) for concentrating flow onto selected locations.

8. Device according to Claim 6 or 7, **characterized in that** the template (10) comprises a metal sheet which is held at a distance from the plastic sheet (1).

9. Device according to Claim 6 or 7, **characterized in that** the template (11) comprises an areal material of low thermal conductivity.

10. Device according to Claim 8 or 9, **characterized in that** the template (12) has an interior (13) for accommodating a cooling medium.

## Revendications

1. Procédé pour braser des composants électriques (2, 3) en des points de brasage pourvus de matériau de brasage et disposés sur une feuille de matière plastique (1) munie de pistes conductrices déposées, **caractérisé en ce que** la feuille de matière plastique (1) est chauffée à une température inférieure à sa température d'altération par son côté orienté à l'opposé des composants (2, 3) et, après le chauffage, son côté orienté à l'opposé des composants est isolé thermiquement et son côté tourné vers les composants (2, 3) est ensuite exposé à un courant de gaz de chauffe (9) qui, par l'intermédiaire d'un gabarit (5) pourvu de fenêtres (6, 7), est concentré aux endroits à braser.

2. Procédé selon la revendication 1, **caractérisé en ce que** le chauffage de la feuille de matière plastique (1) et l'exposition à la chaleur du côté de la feuille de matière plastique (1) tourné vers les composants (2, 3) s'effectuent sensiblement en même temps.

3. Procédé selon la revendication 1 ou 2, **caractérisé en ce que**, la feuille de matière plastique (1) étant immobilisée, la température du courant de gaz de chauffe (9) est réglée de façon à d'abord préchauffer les points de brasage pendant une durée permettant d'activer le matériau de brasage, après quoi la température du courant de gaz de chauffe (9) est brièvement augmentée jusqu'à la fusion du métal de brasage contenu dans le matériau de brasage et est ensuite rapidement baissée.

4. Procédé selon la revendication 3, **caractérisé en ce que** le courant de gaz de chauffe (9) est coupé après la fusion.

5. Procédé selon la revendication 3, **caractérisé en ce que** le courant de gaz de chauffe (9) est transformé en un courant de refroidissement.

6. Dispositif pour braser des composants électriques (2, 3) en des points de brasage pourvus de matériau de brasage et disposés sur une feuille de matière plastique (1) munie de pistes conductrices déposées, **caractérisé en ce que** la feuille de matière plastique (1) est chauffée à une température inférieure à sa température d'altération par son côté orienté à l'opposé des composants (2, 3) et, après le chauffage, ce côté orienté à l'opposé des composants est isolé thermiquement et le côté tourné vers les composants (2, 3) est ensuite exposé à un courant de gaz de chauffe (9) qui, par l'intermédiaire d'un gabarit (5) pourvu de fenêtres (6, 7), est concentré aux endroits à braser, avec une soufflante à gaz de chauffe (9) qui est disposée sur le côté de la feuille de matière plastique (1) où sont placés les composants (2, 3) et devant laquelle la feuille de matière plastique (1) est positionnable, le gabarit (5) étant disposé de manière insérable entre la soufflante à gaz de chauffe (9) et la feuille de matière plastique (1), **caractérisé en ce que** sur le côté de la feuille de matière plastique (1) orienté à l'opposé de la soufflante à gaz de chauffe (9) est prévue, pour le préchauffage de la feuille de matière plastique (1), une plaque chauffante (4) qui, du point de vue de la distance par rapport à la feuille de matière plastique (1), est disposée de manière réglable, de façon à être maintenue au moins à une faible distance de la feuille de matière plastique (1) pour chauffer celle-ci et à une distance supérieure pour l'isoler.

7. Dispositif selon la revendication 6, **caractérisé en ce que** la soufflante à gaz de chauffe est pourvue de sorties positionnables (14) pour concentrer l'écoulement sur des endroits sélectionnés.

8. Dispositif selon la revendication 6 ou 7, **caractérisé en ce que** le gabarit (10) est réalisé en tôle métallique maintenue à distance de la feuille de matière plastique (1).

9. Dispositif selon la revendication 6 ou 7, **caractérisé en ce que** le gabarit (11) est réalisé en matériau plat à faible conductibilité thermique.

10. Dispositif selon la revendication 8 ou 9, **caractérisé en ce que** le gabarit (12) comporte un compartiment intérieur (13) pour recevoir un agent de refroidissement.
